Europäisches Patentamt

European Patent Office

Office européen des brevets

(19)

(11) Publication number: **0 186 521 B1**

# EUROPEAN PATENT SPECIFICATION

(12)

(45) Date of publication of patent specification: **30.10.91**   (51) Int. Cl.⁵: **G01R 25/00, H04N 17/02**

(21) Application number: **85309519.8**

(22) Date of filing: **30.12.85**

(54) **Digital phase difference detecting circuit.**

(30) Priority: **25.12.84 JP 281703/84**
      **25.12.84 JP 281704/84**
      **25.12.84 JP 201613/84 U**

(43) Date of publication of application:
      **02.07.86 Bulletin 86/27**

(45) Publication of the grant of the patent:
      **30.10.91 Bulletin 91/44**

(84) Designated Contracting States:
      **DE FR GB NL**

(56) References cited:

**PATENT ABSTRACTS OF JAPAN, vol. 7, no. 238 (P-231)[1383], 22nd October 1983; & JP - A - 58 123 469**

**PATENT ABSTRACTS OF JAPAN, vol. 5, no. 81 (P-63)[753]; & JP - A - 56 27664**

**PATENT ABSTRACTS OF JAPAN, vol. 3, no. 38 (E-101), 30th March 1979; & JP - A - 54 15784**

**RUNDFUNKTECHNISCHE MITTEILUNGEN, vol. 28, no. 3, May/June 1984, pages 121-133, Norderstedt; G. WELZ "Verfahren zur Messung der F/H-Phase und Überprüfung der F/H-Phasenstabilität"**

(73) Proprietor: **VICTOR COMPANY OF JAPAN, LIMITED**
      **12, 3-chome, Moriya-Cho Kanagawa-ku Yokohama-Shi Kanagawa-Ken 221(JP)**

(72) Inventor: **Ozaki, Hidetoshi**
      **No. 3-56-9, Kamiishihara**
      **Chofu-Shi Tokyo(JP)**
      Inventor: **Kobayashi, Kaoru**
      **No. 610, Jindaiji Kanagawa-Ku**
      **Yokohama-Shi Kanagawa-Ken(JP)**

(74) Representative: **Robinson, John Stuart et al Marks & Clerk Alpha Tower Suffolk Street Queensway Birmingham, B1 1TT(GB)**

## Description

The present invention generally relates to digital phase difference detecting circuits, and more particularly to a digital phase difference detecting circuit which detects a phase difference between an input signal and a reference signal with a high speed.

A phase difference between an input signal and a reference signal is obtained in various kinds of signal processing. An analog circuit or a digital circuit which detects the phase difference is generally constituted by a phase comparing circuit comprising a multiplier. However, the linearity of a phase difference output of such a phase comparing circuit is poor, and there is a disadvantage in that the phase difference output becomes distorted in the form of a sinusoidal curve. In the case of the analog phase comparing circuit, the circuit is easily affected by causes such as a change in the ambient temperature and the lapse of time, and it is difficult to manufacture the circuit in the form of an integrated circuit. On the other hand, such problems seen in the analog phase comparing circuit do not occur in the case of the digital phase comparing circuit.

However, in the case of the digital phase comparing circuit, when the input digital signal represents a signal having an amplitude modulated signal component, the amplitude modulated signal component appears in the phase difference output of the digital phase comparing circuit. Hence, in this case, there is a serious disadvantage in that it is impossible to accurately detect the phase difference between the input signal and the reference signal.

Patent Abstracts of Japan, Volume 3, No.38, (E-101), 30.03.79 and JP-A-5 415 784 discloses a digital phase difference detecting circuit which receives an input signal that has been sampled with a predetermined sampling period. This circuit includes dividing means for performing a division in order to obtain a cotangent.

Patent Abstracts of Japan, Volume 7, No.238, (P-231) [1383], 22.10.83 and JP-A-58 123 469 discloses a phase difference detecting circuit having a phase shifting means (in the form of a differentiator) for shifting by $+90°$ or $-90°$ the phase of an input signal. The circuit further comprises subtracting means and operation means for performing an inverse trigonometric function operation.

According to the invention, there is provided a digital phase difference detecting circuit as defined in the appended Claim 1.

Preferred embodiments of the invention are defined in the other appended claims.

It is thus possible to accurately detect the phase difference between the signal represented by the input digital signal and the reference signal even when the signal represented by the input digital signal includes an amplitude modulated signal component. In addition, the phase difference can be detected with a high speed compared to the case where the phase difference is detected by an analog signal processing. Moreover, the digital phase difference detecting circuit is unaffected by a change in the ambient temperature, lapse of time and the like, and the circuit can easily be manufactured in the form of an integrated circuit. Further, it is possible to positively detect the phase difference even when the number of waves represented by the input signal is small, and the linearity of the phase difference output which is obtained is satisfactory. In the case where the signal represented by the input digital signal is a color burst signal which is obtained by digitising a carrier chrominance signal sampled with a predetermined sampling period, it is possible to obtain from the subtracting means an automatic phase control signal for use in an automatic phase control circuit.

An embodiment of the invention further comprises second operation means for performing a trigonometric function operation on the output signal of the first operation means, and second dividing means for performing a division between the output signal of the second operation means and the input digital signal and for producing an envelope detection signal of the input signal, the input digital signal representing an amplitude modulated signal. It is thus possible to detect the envelope of the amplitude modulated signal with a high speed by use of the output signal of the first operation means, with the use of a simple circuit. In the case where the signal represented by the input digital signal is the color burst signal, it is possible to obtain from the second dividing means an automatic chroma control signal for use in an automatic chroma control circuit. On the other hand, in the case where the signal represented by the input digital signal is an amplitude modulated signal, it is possible to obtain from the second dividing means the demodulated amplitude modulated signal.

The present invention will be further described, by way of example, with reference to the accompanying drawings, in which:

Figure 1 is a system block diagram showing a first embodiment of the digital phase difference detecting circuit according to the present invention;

Figure 2 is a system block diagram showing a second embodiment of the digital phase difference detecting circuit according to the present invention;

Figure 3 shows phase data stored in a read only memory (ROM) within the block system shown in Figure 2 in correspondence with addresses in the ROM;

Figure 4 shows magnitudes of data of a ROM address control signal obtained from an adder within the block system shown in Figure 2;

Figure 5 is a system block diagram showing a third embodiment of the digital phase difference detecting circuit according to the present invention;

Figure 6 shows a circuit for extracting a color burst signal from a carrier chrominance signal;

Figure 7 is a system block diagram showing a fourth embodiment of the digital phase difference detecting circuit according to the present invention; and

Figure 8 is a system block diagram showing a fifth embodiment of the digital phase difference detecting circuit according to the present invention.

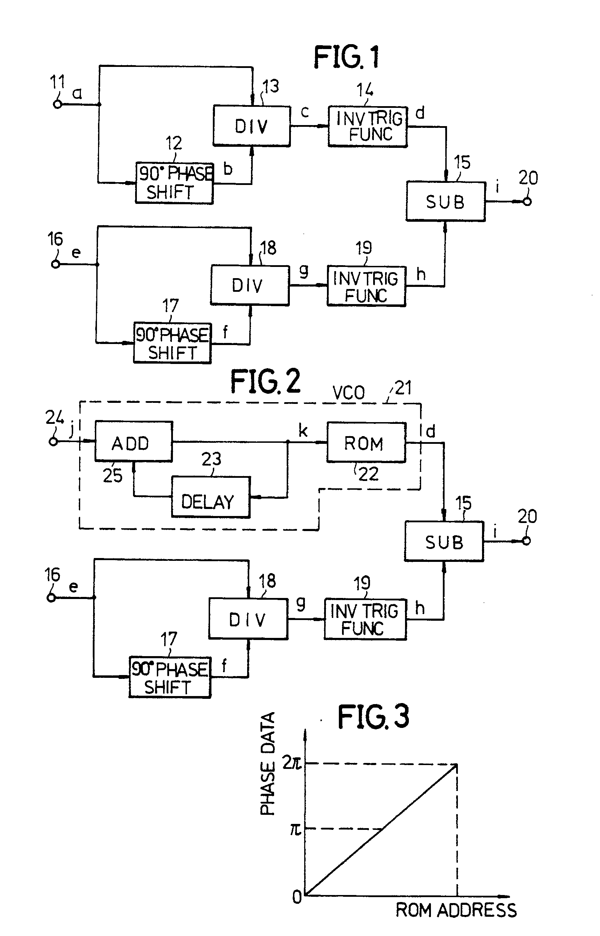

Figure 1 shows the first embodiment of the digital phase difference detecting circuit according to the present invention. A reference input signal a representing a reference signal described by $Asin(2\pi fct + \theta_1)$ is applied to an input terminal 11, where A represents the amplitude, fc represents the frequency, and $\theta_1$ represents the phase. The reference input signal a is a digital signal and represents the reference signal. It has been generated by sampling the reference signal with a predetermined sampling period and by digitising this sampled reference signal. The reference input signal a is passed through a 90° phase shifting circuit 12 and is supplied to a dividing circuit 13 on one hand, and is supplied directly to the dividing circuit 13 on the other. The 90° phase shifting circuit 12 shifts the phase of the reference signal represented by the reference input signal a by 90° and supplies to the dividing circuit 13 a signal b representing a signal described by $Acos(2\pi fct + \theta_1)$. Hence, the dividing circuit 13 generates a signal c representing a signal described by $a/b = \tan(2\pi fct + \theta_1)$ and supplies this signal c to an inverse trigonometric function operation circuit 14. The inverse trigonometric function operation circuit 14 performs an operation $\tan^{-1}c$ and generates a digital reference signal d representing a signal described by $2\pi fct + \theta_1$. This signal d is supplied to a subtracting circuit 15.

On the other hand, an input digital signal e representing an input signal described by $Bsin(2\pi fct + \theta_2)$ is applied to an input terminal 16, where B represents the amplitude, fc represents the frequency, and $\theta_2$ represents the phase. The input digital signal e is also a digital signal and represents the input signal. It has been generated by sampling the input signal with a predetermined sampling period and by digitising this sampled input signal. The input digital signal e is passed through a 90° phase shifting circuit 17 and is supplied to a dividing circuit 18 on one hand, and is supplied directly to the dividing circuit 18 on the other. The 90° phase shifting circuit 17 shifts the phase of the input signal represented by the input digital signal e by 90° and supplies to the dividing circuit 18 a signal f representing a signal described by $Bcos(2\pi fct + \theta_2)$. Hence, the dividing circuit 18 generates a signal g representing a signal described by $e/f = \tan(2\pi fct + \theta_2)$ and supplies this signal g to an inverse trigonometric function operation circuit 19. The inverse trigonometric function operation circuit 19 performs an operation $\tan^{-1}g$ and generates a signal h representing a signal described by $2\pi fct + \theta_2$. This signal h is supplied to the subtracting circuit 15.

The subtracting circuit 15 obtains a difference d-h of the signals d and h, and supplies to an output terminal 20 a signal i described by $i = \theta_1 - \theta_2$ as a phase difference output.

It is possible to use -90° phase shifting circuits which shiff the phase by -90° instead of the 90° phase shifting circuits 12 and 17. In this case, the inverse trigonometric function operation circuits 14 and 19 should be designed to perform operations $-\tan^{-1}c$ and $-\tan^{-1}g$, respectively.

In addition, it is possible to use dividing circuits which respectively perform divisions b/a and f/e instead of the dividing circuits 13 and 18. In this case, the inverse trigonometric function operation circuits 14 and 19 should be designed to perform operations $\cot^{-1}c$ and $\cot^{-1}g$, respectively.

Figure 2 shows the second embodiment of the digital phase difference detecting circuit according to the present invention. In Figure 2, those parts which are the same as those corresponding parts are designated by the same reference numerals, and description thereof will be omitted. In the present embodiment, a type of voltage controlled oscillator (VCO) 21 comprising a read only memory (ROM) 22 is used as a digital reference signal source. Phase data shown in Figure 3 are stored in the ROM 22 in correspondence with addresses in the ROM 22. A 1-clock delay circuit 23 is driven by a clock signal which is the same as a sampling clock signal used when performing the sampling to obtain the input digital signal e.

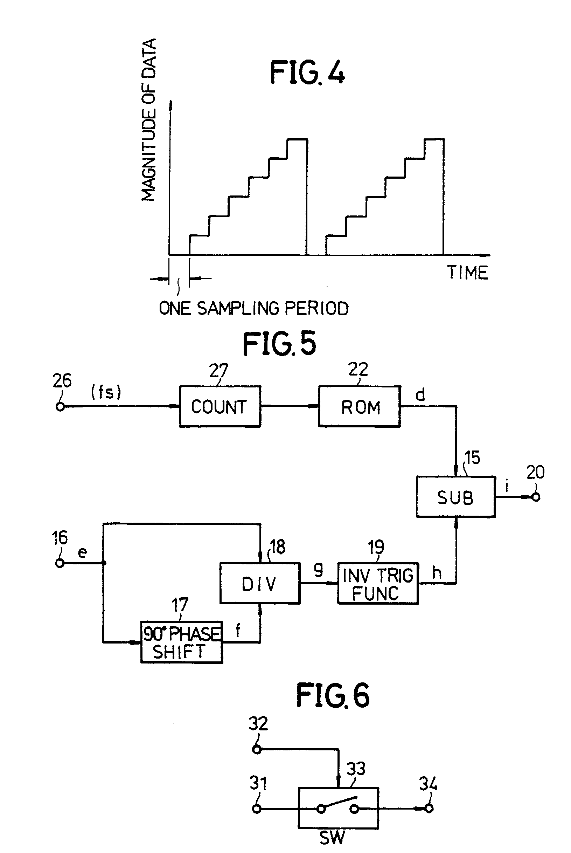

Data j in accordance with a reference signal oscillation frequency which is to be generated are applied to an input terminal 24. The data j are supplied to an adder 25, and an output signal of the adder 25 is delayed in the delay circuit 23 and is then supplied to the adder 25. In other words, the adder 25 and the delay circuit 23 constitute a circuit for generating a ROM address control signal, and the adder 25 supplies a ROM address control signal k to the ROM 22. The adder 25 adds the data j from the input terminal 24 and the delayed data from the delay circuit 23 for every one sampling period, but since the bit length of the adder 25 is finite, the adder 25 overflows with a specific period. Accordingly, the magnitude of the data of the ROM address control signal k changes as shown in Figure 4.

When the ROM address control signal k is supplied to the ROM 22, a read-out address of the ROM 22 is successively renewed according to the clock signal, and a phase datum out of phase data of zero to $2\pi$ (a datum out of a function table), that is, a signal identical to the digital reference signal d ($d = 2\pi fct + \theta_1$) of the inverse trigonometric function operation circuit 14 shown in Figure 1 is read out from the ROM 22 and is supplied to the subtracting circuit 15. As a result, similarly as in the case of the first embodiment described before, the phase difference $\theta_1 - \theta_2$ between the digital reference signal a and the input digital signal e is obtained from the subtracting circuit 15.

Figure 5 shows the third embodiment of the digital phase difference detecting circuit according to the present invention. In Figure 5, those parts which are the same as those corresponding parts in Figure 2 are designated by the same reference numerals, and description thereof will be omitted. In the present embodiment, it will be assumed that an equation fs = Nfc stands between the reference signal frequency fc and a sampling frequency fs, where N is an integer greater than or equal to three.

A clock signal having the sampling frequency fs is applied to an input terminal 26. A counter 27 is designed to repeat an operation of counting N clock pulses in the clock signal. A counted value in the counter 27 is supplied to the ROM 22. Accordingly, the read-out address of the ROM 22 is renewed for every N-count, and a phase datum out of the phase data of zero to $2\pi$ is read out from the ROM 22 and is supplied to the subtracting circuit 15. As a result, similarly as in the cases of the embodiments described before, the phase difference $\theta_1 - \theta_2$ between the digital reference signal a and the input digital signal e is obtained from the subtracting circuit 15.

In the case where an equation fs = 4Mfc stands between the reference signal frequency fc and the sampling frequency fs, where M is an integer greater than or equal to one, an M-clock delay circuit for delaying the input digital signal e by M clock pulses of the clock signal may be used for the 90° phase shifting circuit 17 shown in Figures 1, 2 and 5.

Hilbert filters may be used for the 90° phase shifting circuits 12 and 17.

Circuits such as the 90° phase shifting circuits 12 and 17, the dividing circuits 13 and 18, the subtracting circuit 15, the inverse trigonometric function operation circuits 14 and 19, and the delay circuit 23 may be constituted by a circuit which comprises a ROM stored with a function table and carries out the operation of a specific circuit by reading out desired data from the ROM.

Next, description will be given with respect to a case where the input digital signal e is a sampled and digitised color burst signal. The color burst signal may be obtained from a circuit shown in Figure 6, for example. A carrier chrominance signal is applied to an input terminal 31, and a burst gate pulse is applied to an input terminal 32. A switching circuit 33 is turned ON by the burst gate pulse, and thus, only the color burst signal within the carrier chrominance signal is extracted and supplied to an output terminal 34. The color burst signal from the output terminal 34 is sampled and digitised, and applied to the input terminal 16 in Figure 1, 2 or 5 as the input signal e. In this case, the signal i obtained from the output terminal 20 indicates a difference between the digital reference signal d and the phase of the color burst signal. For this reason, the signal i can be used as an automatic phase control (APC) signal for use in an automatic phase control (APC) circuit (not shown) which automatically adjusts the phase of the carrier chrominance signal.

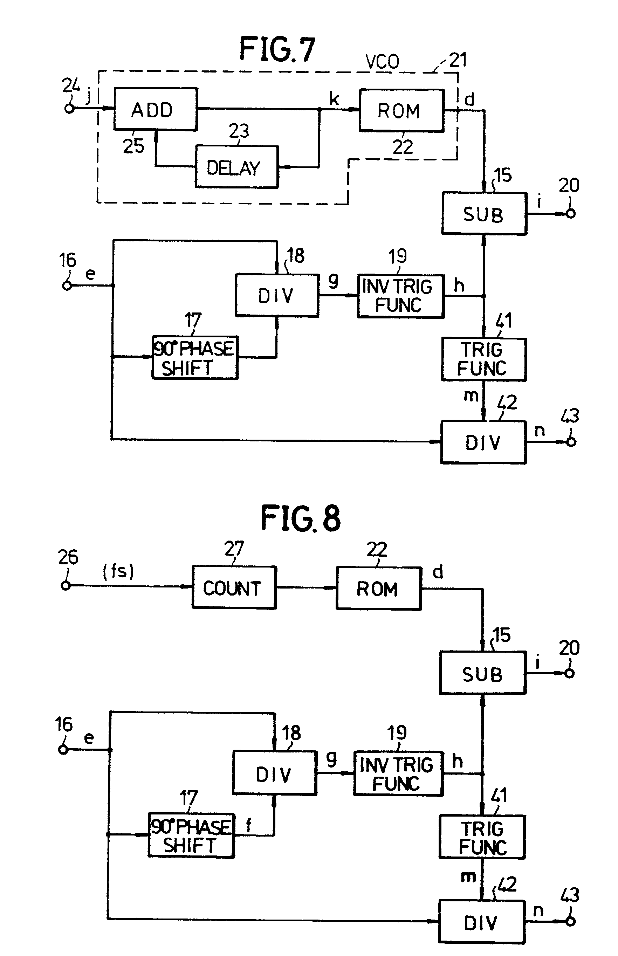

Figure 7 shows the fourth embodiment of the digital phase difference detecting circuit according to the present invention. In Figure 7, those parts which are the same as those corresponding parts in Figure 2 are designated by the same reference numerals, and description thereof will be omitted. There output signal h of the inverse trigonometric function operation circuit 19 is also supplied to a trigonometric function operation circuit 41. The trigonometric function operation circuit 41 performs an operation sinh and generates a signal m representing a signal described by $\sin(2\pi fct + \theta_2)$. This signal m is supplied to a dividing circuit 42. The dividing circuit 42 performs a division described by n = e/m and supplies to an output terminal 43 a signal n described by n = B. As described before, B represents the amplitude of the signal represented by the input digital signal e. Hence, in the case where the input digital signal e represents the color burst signal, the signal n can be used as an automatic chroma control (ACC) signal for use in an automatic chroma control (ACC) circuit (not shown) which automatically adjusts the saturation of the carrier chrominance signal.

On the other hand, in the case where the input digital signal e represents an amplitude modulated (AM) signal, the AM signal can be described by C-$[1 + DV(t)]\sin(2\pi fct)$, where C represents the amplitude of the carrier, D represents the amplitude modulation factor, V(t) represents the modulating signal, and fc represents the frequency of the carrier. In this case, the output signal f of the 90° phase shifting circuit 17 represents a signal described by $C[1 + DV(t)]\cos(2\pi fct)$. The output signal g of the dividing circuit 18 represents a signal described by $\tan(2\pi fct)$, and the output signal h of the inverse trigonometric function operation circuit 19 represents a signal described by $2\pi fct$. Accordingly, the output signal m of the trigonometric function operation circuit 41 represents a signal described by $\sinh = \sin(2\pi fct)$, and the output signal n of the dividing circuit 42 represents a signal described by $e/m = C[1 + DV(t)]$. Because C represents the amplitude of the carrier and is constant, this can be simplified to $1 + DV(t)$ when it is assumed that $C = 1$. In the expression $1 + DV(t)$, the first term "1" is a D.C. component. Therefore, a digital representation of an AM signal component having the D.C. component added thereon, that is, of an envelope of the AM signal, is obtained from the output terminal 43. In other words, a demodulated output of the AM signal is obtained from the output terminal 43.

Hence, according to the present embodiment, it is possible to detect the envelope of an AM signal represented by the input digital signal e by use of the output signal h of the inverse trigonometric function operation circuit 19, with the use of a simple circuit.

Figure 8 shows the fifth embodiment of the digital phase difference detecting circuit according to the present invention. In Figure 8, those parts which are the same as those corresponding parts in Figures 5 and 6 are designated by the same reference numerals, and description thereof will be omitted. In the present embodiment, substantially the same results are obtained as in the case of the fourth embodiment described before.

Next, description will be given with respect to the case where the input digital signal e represents a signal including an AM signal component. For example, it will be assumed for convenience' sake that the input digital signal e represents a signal described by $E[1 + F\cos\theta_3(t)]\cos\theta_2(t)$ and the reference input signal a represents a reference signal described by $G\sin\theta_1(t)$. The conventional phase comparing circuit comprising the multiplier obtains the phase difference output by performing the following operation.

$E[1 + F\cos\theta_3(t)]\cos\theta_2(t) \times G\sin\theta_1(t)$
$= (EG/2)[1 + F\cos\theta_3(t)]\sin[\theta_2(t) + \theta_1(t)]$
$-(EG/2)[1 + F\cos\theta_3(t)]\sin[\theta_2(t) - \theta_1(t)]$

As is clear from the above multiplication result, the AM signal component of the input signal represented by the input digital signal e appears in the phase difference output.

On the other hand, according to the digital phase difference detecting circuit of the present invention, the output signal d (i.e. the digital reference signal d) of the inverse trigonometric function operation circuit 14 (or the ROM 22) represents a signal described by $\tan^{-1}c = \tan^{-1}(a/b)$ in the described embodiments, and hence, by $\tan^{-1}[G\sin\theta_1(t)]/[G\cos\theta_1(t)] = \theta_1(t)$. In addition, the output signal h of the inverse trigonometric function operation circuit 19 represents a signal described by $\tan^{-1}g = \tan^{-1}(e/f)$ in the described embodiments, but as described before, the signal represented by signal h may be described by $-\tan^{-1}g = -\tan^{-1}(f/e)$, which gives $-\tan^{-1}-E[1 + F\cos\theta_3(t)]\sin\theta_2(t)/E[1 + F\cos\theta_3(t)]\cos\theta_2(t) = -[-\theta_2(t)] = \theta_2(t)$. Accordingly, a phase difference output described by $i = \theta_1(t) - \theta_2(t)$ is obtained from the subtracting circuit 20. Therefore, the AM signal component of the signal represented by the input digital signal e is not included in the phase error output, and it is possible to accurately obtain the phase error output.

## Claims

1. A digital phase difference detecting circuit for an input digital signal e which has been generated by digitising an input signal which has been sampled with a predetermined sampling period, including first dividing means (18) for performing a division, the circuit being characterised in that: there is provided first phase shifting means (17) for shifting by $+90°$ or $-90°$ the phase of said input signal represented by the input digital signal e; said first dividing means (18) is arranged to perform a division between the output signal f of said first phase shifting means (17) and said input digital signal e; there is provided first operation means (19) for performing an inverse trigonometric function operation on the output signal g of said first dividing means (18); and there is provided subtracting means (15) for obtaining a difference between the output signal h of said first operation means (19) and a digital reference signal d, representing a reference signal, so as to obtain the phase difference between said input signal and said reference signal.

2. A digital phase difference detecting circuit as claimed in Claim 1, in which said digital reference signal d has been generated from a reference input signal a generated by digitising the reference signal sampled with a predetermined sampling period, the digital phase difference detecting circuit further being characterized in that it comprises second phase shifting means (12) for shifting the phase of said reference signal represented by the reference input signal a by +90° or -90°, second dividing means (13) for performing a division between the output signal b of said second phase shifting means (12) and said reference input signal a, and second operation means (14) for performing an inverse trigonometric function operation on the output signal c of said second dividing means (13), said second operation means (14) supplying an output signal thereof to said subtracting means (15) as the digital reference signal d.

3. A digital phase difference detecting circuit as claimed in Claim 1, characterized in that there are further provided memory means (22) stored with phase data which linearly vary from zero to $2\pi$ depending on addresses thereof, and address generating means (23, 25; 27) for generating an address signal k which varies monotonical with a specific period, a phase datum which is read out from a read-out address in said memory means (22) designated by an address signal k of said address generating means being supplied to said subtracting means (15) as said digital reference signal d.

4. A digital phase difference detecting circuit as claimed in Claim 3, characterised in that said address generating means comprises adding means (25) supplied with predetermined data defining the oscillation frequency of the reference signal whose phase is represented by said digital reference signal d, and delay means (23) for delaying the output signal of said adding means by said predetermined sampling period, said adding means adding said predetermined data and the output signal of said delay means, the output signal of said adding means being supplied to said memory means (22) as said address signal k.

5. A digital phase difference detecting circuit as claimed in Claim 3, characterized in that an equation fs = Nfc stands, where fc represents the frequency of said reference signal, fs represents the sampling frequency, and N is an integer greater than or equal to three, said address generating means comprising a counter (27) which repeats an operation of counting N pulses of a signal having said sampling frequency fs, said counter supplying the output thereof to said memory means (22) as said address signal.

6. A digital phase difference detecting circuit as claimed in Claim 3, characterized in that said memory means comprises a read only memory (22).

7. A digital phase difference detecting circuit as claimed in Claim 3, characterized in that there are further provided second operation means (41) for performing a trigonometric function operation on the output signal h of said first operation means (19), and second dividing means (42) for performing a division between the output signal m of said second operation means (41) and said input digital signal e, said second dividing means producing an envelope detection signal n of said input signal which is amplitude modulated and is represented by said input digital signal e.

8. A digital phase difference detecting circuit as claimed in Claim 7, in which said input digital signal e represents a color burst signal of a carrier chrominance signal, characterized in that said subtracting means (15) produces an output signal i thereof as an automatic phase control signal which is used for automatically adjusting the phase of the carrier chrominance signal, and said second dividing means (42) produces the output envelope detection signal n thereof as an automatic chroma control signal for automatically controlling the saturation of the carrier chrominance signal.

9. A digital phase difference detecting circuit as claimed in Claim 1, characterized in that an equation fs = 4Mfc stands, where fc represents the frequency of a reference signal whose phase is represented by the digital reference signal d, fs represents the sampling frequency, and M is an integer greater than or equal to one, said first phase shifting means (17) comprising delay means for delaying said input digital signal e by a time period which is M times said sampling period.

10. A digital phase difference detecting circuit as claimed in Claim 1, characterized in that said first dividing means (18) produces a signal g representing a signal described by e/f, where e represents said input digital signal and f represents the output signal of said first phase shifting means (17), and said first operation means (19) produces a signal h representing a signal described by $\tan^{-1}g$.

11. A digital phase difference detecting circuit as claimed in Claim 1, characterized in that said first phase shifting means (17), said first dividing means (18), said first operation means (19), and said subtracting means (15) respectively perform a specific operation dependent on a function table stored in a read only memory.

## Revendications

1. Un circuit numérique de détection de différence de phase pour un signal numérique d'entrée e qui a été généré en numérisant un signal d'entrée qui a été échantillonné avec une période d'échantillonnage prédéterminée, comprenant de premiers moyens diviseurs (18) pour exécuter une division, le circuit étant caractérisé en ce qu'il est prévu de premiers moyens de déphasage (17) pour décaler de +90° ou -90° la phase dudit signal d'entrée représenté par le signal numérique d'entrée e ; lesdits premiers moyens diviseurs (18) sont montés de façon à exécuter une division entre le signal de sortie f desdits premiers moyens de déphasage (17) et ledit signal numérique d'entrée e ; il est prévu de premiers moyens d'opération (19) pour exécuter une opération de fonction trigonométrique inverse sur le signal de sortie g desdits premiers moyens diviseurs (18) ; et il est prévu des moyens de soustraction (15) pour obtenir une différence entre le signal de sortie h desdits premiers moyens d'opération (19) et un signal de référence numérique d représentant un signal de référence de façon à obtenir la différence de phase entre ledit signal d'entrée et ledit signal de référence.

2. Un circuit numérique de détection de différence de phase comme revendiqué à la revendication 1, dans lequel ledit signal de référence numérique d a été formé à partir d'un signal d'entrée de référence a, généré en numérisant le signal de référence échantillonné avec une période d'échantillonnage prédéterminée, le circuit numérique de détection de différence de phase étant caractérisé, de plus, en ce qu'il comporte de seconds moyens de déphasage (12) pour décaler la phase dudit signal de référence représenté par le signal d'entrée de référence a de +90° ou -90°, de seconds moyens diviseurs (13) pour exécuter une division entre le signal de sortie b desdits seconds moyens déphaseurs (12) et ledit signal d'entrée de référence a, et de seconds moyens d'opération (14) pour exécuter une opération de fonction trigonométrique inverse sur le signal de sortie c desdits seconds moyens diviseurs (13), lesdits seconds moyens d'opération (14) fournissant un signal de sortie auxdits moyens de soustraction (15) comme signal de référence numérique d.

3. Un circuit numérique de détection de différence de phase comme revendiqué à la revendication 1, caractérisé en ce qu'il est prévu de plus des moyens de mémorisation (22) qui stockent les données de phase qui varient linéairement entre 0 et 2f selon leurs adresses et des moyens générateurs d'adresse (23, 25 ; 27) pour générer un signal d'adresse k qui varie de façon monotone sur une période définie, une donnée de phase, qui est lue à une adresse de lecture dans lesdits moyens de mémorisation (22) désignée par un signal d'adresse k desdits moyens générateurs d'adresse, étant fournie auxdits moyens de soustraction (15) en tant que ledit signal numérique de référence d.

4. Un circuit numérique de détection de différence de phase comme revendiqué à la revendication 3, caractérisé en ce que lesdits moyens générateurs d'adresse comportent des moyens d'addition (25) alimentés avec des données prédéterminées définissant la fréquence d'oscillation du signal de référence dont la phase est représentée par ledit signal numérique de référence d, et des moyens de retard (23) pour retarder le signal de sortie desdits moyens d'addition par ladite période d'échantillonnage prédéterminée, lesdits moyens d'addition ajoutant lesdites données prédéterminées au signal de sortie desdits moyens de retard, le signal de sortie desdits moyens d'addition étant fournis auxdits moyens de mémorisation (22) en tant que ledit signal d'adresse k.

5. Un circuit numérique de détection de différence de phase comme revendiqué à la revendication 3, caractérisé en ce qu'une équation fs = Nfc est vérifiée, où fc représente la fréquence dudit signal de référence, fs représente la fréquence d'échantillonnage et N est un entier plus grand ou égal à trois, lesdits moyens générateurs d'adresse comprenant un compteur (27) qui répète l'opération de comptage de N impulsions d'un signal ayant ladite fréquence d'échantillonnage fs, ledit compteur fournissant sa sortie auxdits moyens de mémorisation (22) en tant que ledit signal d'adresse.

6. Un circuit numérique de détection de différence de phase comme revendiqué à la revendication 3, caractérisé en ce que lesdits moyens de mémorisation comportent une mémoire morte (22).

7. Un circuit numérique de détection de différence de phase comme revendiqué à la revendication 3, caractérisé en ce qu'il comporte de plus de seconds moyens d'opération (41), pour exécuter une opération de fonction trigonométrique sur le signal de sortie h desdits premiers moyens d'opération (19), et de seconds moyens diviseurs (42), pour exécuter une division entre le signal de sortie m desdits seconds moyens d'opération (41) et ledit signal numérique d'entrée e, lesdits seconds moyens diviseurs produisant un signal de détection d'enveloppe n dudit signal d'entrée qui est modulé en amplitude et est représenté par ledit signal numérique d'entrée e.

8. Un circuit numérique de détection de différence de phase comme revendiqué à la revendication 7, dans lequel ledit signal numérique d'entrée e représente un signal de salve de couleur d'un signal porteur de chrominance, caractérisé en ce que lesdits moyens de soustraction (15) produisent un signal de sortie i comme signal de contrôle automatique de phase qui est utilisé pour ajuster automatiquement la phase du signal porteur de chrominance, et en ce que lesdits seconds moyens diviseurs (42) produisent le signal de sortie de détection d'enveloppe n comme signal de contrôle automatique de couleur pour contrôler automatiquement la saturation du signal porteur de chrominance.

9. Un circuit numérique de détection de différence de phase comme revendiqué à la revendication 1, caractérisé en ce qu'une équation fs = 4Mfc est vérifiée, où fc représente la fréquence d'un signal de référence dont la phase est représentée par le signal de référence numérique d, fs représente la fréquence d'échantillonnage, et M est un entier plus grand ou égal à un, lesdits premiers moyens de déphasage (17) comprenant des moyens à retard pour retarder ledit signal numérique d'entrée e d'une période de temps qui est M fois ladite période d'échantillonnage.

10. Un circuit numérique de détection de différence de phase comme revendiqué à la revendication 1, caractérisé en ce que lesdits premiers moyens diviseurs (18) produisent un signal g représentant un signal décrit par e/f, où e représente ledit signal numérique d'entrée et f représente le signal de sortie desdits premiers moyens de déphasage (17), et en ce que lesdits premiers moyens d'opération (19) produisent un signal h représentant un signal décrit par Arc tg g.

11. Un circuit numérique de détection de différence de phase comme revendiqué à la revendication 1, caractérisé en ce que lesdits premiers moyens de déphasage (17), lesdits premiers moyens de division (18), lesdits premiers moyens d'opération (19) et lesdits moyens de soustraction (15) exécutent respectivement une opération spécifique selon une table de fonction stockée dans une mémoire morte.

## Patentansprüche

1. Digitale Phasendifferenzerfassungsschaltung für ein digitales Eingangssignal e, das durch Digitalisieren eines Eingangssignals erzeugt worden ist, das mit einer vorbestimmten Abtastperiode abgetastet worden ist, aufweisend eine erste Dividiervorrichtung (18) zum Ausführen einer Division, welche Schaltung dadurch gekennzeichnet ist, daß: eine erste Phasenschiebervorrichtung (17) vorgesehen ist, die die Phase des Eingangssignals, das durch das digitale Eingangssignal e dargestellt wird, um +90° oder -90° verschiebt; daß die erste Dividiervorrichtung (18) so ausgelegt ist, daß sie eine Division zwischen dem Ausgangssignal f der ersten Phasenschiebervorrichtung (17) und dem digitalen Eingangssignal e ausführt; daß eine erste Operationsvorrichtung (19) vorgesehen ist, die auf das Ausgangssignal g der ersten Dividiervorrichtung (18) eine inverse trigonometrische Funktionsoperation anwendet; und daß eine Subtrahiervorrichtung (15) vorgesehen ist, die die Differenz zwischen dem Ausgangssignal h der ersten Operationsvorrichtung (19) und einem digitalen Referenzsignal d, das ein Referenzsignal darstellt, liefert, um so die Phasendifferenz zwischen dem Eingangssignal und dem Referenzsignal zu gewinnen.

2. Digitale Phasendifferenzerfassungsschaltung nach Anspruch 1, in der das digitale Referenzsignal d aus einem Referenzeingangssignal a erzeugt worden ist, das durch Digitalisieren des mit einer vorbestimmten Abtastperiode abgetasteten Referenzsignals erzeugt worden ist, wobei die digitale Phasendifferenzerfassungsschaltung ferner dadurch gekennzeichnet ist, daß sie eine zweite Phasenschiebervorrichtung (12) aufweist, die die Phase des durch das Referenzeingangssignal a dargestellten Referenzsignals um +90° oder -90° verschiebt, eine zweite Dividiereinrichtung (13), die eine Division zwischen dem Ausgangssignal b der zweiten Phasenschiebervorrichtung (12) und dem Referenzeingangssignal a ausführt, und eine zweite Operationsvorrichtung (14) aufweist, die auf das Ausgangssignal c der zweiten Dividiervorrichtung (13) eine inverse trigonometrische Funktionsoperation anwendet, wobei die zweite Operationsvorrichtung (14) ihr Ausgangssignal der Subtrahiervorrichtung (15) als das digitale Referenzsignal d zuführt.

3. Digitale Phasendifferenzerfassungsschaltung nach Anspruch 1, **dadurch gekennzeichnet,** daß ferner eine Speichervorrichtung (22) vorgesehen ist, in der Phasendaten gespeichert sind, die linear von Null bis $2\pi$ in Abhängigkeit von Speicheradressen hiervon variieren, und eine Adressenerzeugungsvorrichtung (23, 25; 27), die ein Adreßsignal k, welches monoton mit einer speziellen Periode variiert, erzeugt, wobei ein Phasendatum, das aus einer Ausleseadresse in der Speichervorrichtung (22) ausgelesen wird, welche Adresse durch ein Adreßsignal k von der Adressenerzeugungsvorrichtung bestimmt ist, der Subtrahiervorrichtung (15) als die Phase des digitalen Referenzsignals d zugeführt wird.

4. Digitale Phasendifferenzerfassungsschaltung nach Anspruch 3, **dadurch gekennzeichnet,** daß die Adressenerzeugungsvorrichtung eine Addiervorrichtung (25), der vorbestimmte, die Schwingungsfrequenz des Referenzsignals, dessen Phase durch das digitale Referenzsignal d bestimmt ist, definierende Daten zugeführt werden, und eine Verzögerungsvorrichtung (23) aufweist, die das Ausgangssignal der Addiervorrichtung um diese vorbestimmte Abtastperiode verzögert, wobei die Addiervorrichtung diese vorbestimmten Daten und das Ausgangssignal der Verzögerungsvorrichtung addiert und wobei das Ausgangssignal der Addiervorrichtung als dieses Adreßsignal der Speichervorrichtung (22) als das Adreßsignal k zugeführt wird.

5. Digitale Phasendifferenzerfassungsschaltung nach Anspruch 3, **dadurch gekennzeichnet,** daß eine Gleichung fs = Nfc gilt, wobei fc eine Frequenz des Referenzsignals wiedergibt, fs die Abtastfrequenz wiedergibt und N eine ganze Zahl größer oder gleich drei ist, daß die Adressenerzeugungsvorrichtung einen Zähler (27) aufweist, der eine Operation wiederholt, bei der N Impulse eines Signals gezählt werden, welches diese Abtastfrequenz fs aufweist, und daß dieser Zähler sein Ausgangssignal der Speichervorrichtung (22) als das Adreßsignal zuführt.

6. Digitale Phasendifferenzerfassungsschaltung nach Anspruch 3, **dadurch gekennzeichnet,** daß die Speichervorrichtung einen Nur-Lese-Speicher (22) aufweist.

7. Digitale Phasendifferenzerfassungsschaltung nach Anspruch 3, **dadurch gekennzeichnet,** daß ferner eine zweite Operationsvorrichtung (41) vorgesehen ist, die auf das Ausgangssignal h der ersten Operationsvorrichtung (19) eine trigonometrische Funktionsoperation anwendet, und eine zweite Dividiervorrichtung (42), die bezüglich des Ausgangssignals m der zweiten Operationsvorrichtung (41) und dieses digitalen Eingangssignals e eine Division durchführt, wobei die zweite Dividiervorrichtung vom Eingangssignal, das amplitudenmoduliert ist und durch das digitale Eingangssignal e wiedergegeben wird, ein Hüllkurvenerfassungssignal n bildet.

8. Digitale Phasendifferenzerfassungsschaltung nach Anspruch 7, in welcher das digitale Eingangssignal e ein Farbburstsignal eines Trägerchrominanzsignals darstellt, **dadurch gekennzeichnet,** daß die Subtrahiervorrichtung (15) ein Ausgangssignal i dieser Schaltung als ein Signal für eine automatische Phasenregelung erzeugt, welches dazu benutzt wird, um die Phase des Trägerchrominanzsignals automatisch einzustellen, und daß die zweite Dividiervorrichtung (42) ihr Hüllkurvenerfassungssignal n als ein Signal für eine automatische Chrominanzregelung ausgibt, um die Sättigung des Trägerchrominanzsignals automatisch zu regeln.

9. Digitale Phasendifferenzerfassungsschaltung nach Anspruch 1, **dadurch gekennzeichnet,** daß eine Gleichung fs = 4Mfc gilt, wobei fc die Frequenz des Referenzsignals wiedergibt, dessen Phase durch das digitale Referenzsignal d wiedergegeben wird, fs die Abtastfrequenz darstellt und M eine ganze Zahl größer oder gleich Eins ist, wobei die erste Phasenschiebervorrichtung (17) eine Verzögerungsvorrichtung aufweist, um das digitale Eingangssignal e um eine Zeitperiode zu verzögern, die dem M-fachen der Abtastperiode entspricht.

10. Digitale Phasendifferenzerfassungsschaltung nach Anspruch 1, **dadurch gekennzeichnet,** daß die erste Dividiervorrichtung (18) ein Signal g erzeugt, das durch e/f beschrieben wird, wobei e das digitale Eingangssignal darstellt und f das Ausgangssignal der ersten Phasenschiebervorrichtung (17) wiedergibt, und daß die erste Operationsvorrichtung (19) ein Signal h erzeugt, welches durch $\tan^{-1}g$ beschrieben wird.

11. Digitale Phasendifferenzerfassungsschaltung nach Anspruch 1, **dadurch gekennzeichnet,** daß die erste Phasenschiebervorrichtung (17), die erste Dividiervorrichtung (18), die erste Operationsvorrichtung (19) und die Subtrahiervorrichtung (15) jeweils eine spezielle Funktion in Abhängigkeit von einer Funktionstabelle ausführen, die in einem Nur-Lese-Speicher gespeichert ist.

# FIG.1

# FIG.2

# FIG.3

## FIG. 4

ONE SAMPLING PERIOD

## FIG. 5

## FIG. 6

# FIG.7

# FIG.8